# EUROPEAN PATENT SPECIFICATION

(11) **EP 0 294 159 B1**
(45) Date of publication and mention of the grant of the patent: **21.04.1993**
(21) Application number: 88304957.9
(22) Date of filing: 31.05.1988
(51) Int. Cl.: G01R 31/08

(54) **Branched sensor system**
Verzweigtes Sensorsystem
Système détecteur ramifié

(30) Priority: 03.06.1987 US 57459
(43) Date of publication of application: 07.12.1988
(73) Proprietor: RAYCHEM CORPORATION, Menlo Park California 94025 (US)
(72) Inventor: Koppitsch, Heinrich, D-8012 Ottobrunn (DE); Sparling, Francis, Sunnyvale California 94087 (US)
(74) Representative: Jones, David Colin

(56) References cited:
- EP-A- 0 133 748
- EP-A- 0 160 440
- EP-A- 0 160 441
- US-A- 3 560 850

## Description

This invention relates to a sensor cable for use in detecting and obtaining information about an event.

European Patent Publications Nos. 133,748, 160,440, 144,211, 164,838, 160,441, 191,547, 222,012, and 242,029 disclose methods and apparatus for detecting and obtaining information about (particularly locating) changes in variables. Such changes are referred to in that application, and likewise in this application, by the generic term "event". In a preferred embodiment of such methods, and in other methods, there is used a sensor cable comprising two insulated wires and two "non-insulated" wires which are not connected to each other in the absence of an event but which become electrically connected to each other upon occurrence of an event. The non-insulated wires can for example comprise a metal core surrounded by a conductive polymer jacket, so that the wires become electrically connected if there is a water leak. The possibility of connection can for example exist at all points along an elongate path or over selected stretches or at discrete locations of an elongate path; for example the non-insulated wires can be wires which are insulated except at spaced locations and which can become connected at one or more of those locations through a switch which is switched on by occurrence of an event at the location of that switch.

When such a four-wire sensor cable is used to detect events along a path comprising one or more branch paths extending from a main (or trunk) path, the cable can simply be routed along the branch path to the end of the branch path and then straight back to the trunk path. However, this can lead to misleading results, since an event taking place along the branch can cause connection of the non-insulated wires in both the outgoing branch cable and the incoming branch cable. This problem can be overcome by running the sensor cable from the junction of the trunk and branch paths to the end of the branch path only, and using four insulated "jumper" wires to make the appropriate connections from the end of the branch back to the trunk; but this is an expensive and inconvenient solution, especially when space is limited, eg. in a double containment system.

EP-A-0 133 748 discloses, with respect to its Figure 24, an arrangement for locating events along a branched path. In this arrangement, occurrence of an event results in a connection being made between an electrically conductive locating member and an electrically conductive source member such that a test circuit is formed with a power source, whereby measurement of a voltage drop in the circuit can be used to determine the location of the event. However there are difficulties associated with this disclosed arrangement in ensuring an unambiguous location of the event.

We have now recognized that in a branched system using a four-wire sensor cable, the two insulated wires are not needed in the branch line to perform the functions for which they are needed when the four wire sensor cable is part of a trunk line, and that these insulated wires can, therefore, be used (a) as insulated jumper wires to connect the non-insulated wires between the junction of a branch and the end of a branch, or (b) can be connected to each other at the end of a branch and to incoming and outgoing ends of one of the insulated wires at the junction of a branch, thus providing a loop around the branch for continuity checking purposes.

Therefore, the insulated wires of the trunk cable are simply connected to each other across the junction; the non-insulated wires of the branch are connected (a) at the junction, to the non-insulated wires coming into (or going out of) the junction along the trunk path, and (b) at the end of the branch, to the insulated wires of the branch; and the insulated wires of the branch are connected at the junction to the non-insulated wires going out of (or coming into) the junction along the trunk path. In this way the errors which can occur with a simple loop system are substantially reduced or eliminated, as is the expense of the return leg of the four-wire sensor cable, or the inconvenience and expense of using separate jumper wires. Furthermore, the connections which have to be made at the end of the branch line can be the same as those made at the end of the trunk line, so that the same termination apparatus can be used.

Thus, in accordance with the present invention, there is provided a sensor cable for use in detecting and obtaining information about an event, the cable comprising
(A) a trunk line cable which follows an elongate trunk path having a near end and a far end; and which comprises elongate electrically conductive members; and
(B) at least one branch line cable which also comprises elongate electrically conductive members and which extends from the trunk line cable at an intermediate point along the trunk path and follows an elongate branch path from the intermediate point to a distant point;

the occurrence of an event resulting in an electrical connection between two of said elongate electrically conductive members, characterized in that
the trunk line cable comprises four elongate electrically conductive members,
each of the first and second members running along the whole length of the trunk path but being discontinuous at each intermediate point to provide an incoming end nearer to the near end of the trunk path and an outgoing end nearer to the far end of the trunk path,
each of the third and fourth members running continuously along the whole length of the trunk path,
the first and third members being electrically connected to each other at the far end of the trunk cable, and the second and fourth members being electrically connected to each other at the far end of the trunk cable;
the at least one branch line cable comprises a fifth, sixth, seventh, and eighth elongate electrically conductive member, each of which runs continuously along the whole length of the branch path and has a first end at the intermediate point and a second end at the distant point;
each of the first ends of the fifth, sixth, seventh and eighth members is respectively connected to one of the incoming and outgoing ends of the first and second members, and each of the second ends of the fifth and sixth members is respectively connected to each of the second ends of the seventh and eighth members;
the first and second members (a) are, in the absence of an event, insulated from each other and from other components of the cable along the length of the cable except for said connections at each intermediate point and at the far end of the trunk cable, and (b) become, upon occurrence of an event at a point along the trunk path electrically connected to each other at said point;
the third and fourth members are, both in the absence of an event and upon occurrence of an event, electrically insulated from each other and from other components of the cable, along the length of the cable, except for said connections at the far end of the trunk cable;
the fifth and sixth members (a) are, in the absence of an event, insulated from each other and from other components of the cable except for said connections at each intermediate point and distant point, and (b) become, upon occurrence of an event at a point along the branch path, electrically connected to each other at that point; and
the seventh and eighth members are, both in the absence of an event and upon occurrence of an event, electrically insulated from each other and from other components of the cable except for said connections at each intermediate point and distant point.

In the case of a sensor cable according to the invention, apparatus for detecting and obtaining information about the event is preferably such that, upon occurrence of the event at a location along the cable, an electrical connection is made at that location either between the first and second members or between the fifth and sixth members; and the making of said connection resulting in a system in which
(i) the first member is electrically connected (a) at the near end of the trunk path, to a power source and to a voltage-measuring device, and (b) at the far end of the trunk path, to the third member;
(ii) the third member is electrically connected (a) at the near end of the trunk path, to the voltage-measuring device, and (b) at the far end of the trunk path, to the first member;
(iii) the fourth member is electrically connected (a) at the near end of the trunk path, to the power source, and (b) at the far end of the trunk path, to the second member;
(iv) there is a test circuit in which a current of known size flows and which comprises
   (a) those parts of the second, sixth and seventh members which lie between the connection point and the far end of the trunk path,
   (b) the connection;
   (c) those parts of the first, fifth and eighth members which lie between the connection point and the near end of the trunk path,
   (d) the fourth member of the trunk cable, and
   (e) the power source,
   and
(v) there is a reference circuit which comprises
   (a) the first, fifth and eighth members,
   (b) the third member, and
   (c) the voltage-measuring device;

whereby the voltage measured by the voltage-measuring device can be used to determine the location of the connection point. If desired, the apparatus can be such that, in the absence of an event, no current flows through the first to eighth elongate members. Alternatively, there can be a current which is relatively low by comparison with the current of known size which flows in the test circuit, for example for continuity checking purposes.

In preferred apparatus of this kind, at all points on the sensor cable at which occurrence of an event can cause connection between the first and second members or the fifth and sixth members, the sum of (a) the resistances of the first, fifth and eighth members and any resistors in series therewith, between the near end and the connection point, and (b) the resistances of the second, sixth and seventh members and any resistors in series therewith, between the connection point and the far end, is substantially independent of the location of the connection point.

In order to achieve this result, it is preferred that the sensor cable is arranged such that:
(i) the incoming ends of the first and second members at each intermediate point are connected to the first ends of the fifth and sixth members respectively, or to the first ends of the seventh and eighth members respectively;
(ii) the outgoing ends of the first and second members at each intermediate point are connected to the first ends of the eighth and seventh members respectively, or to the first ends of the fifth and sixth members respectively,
(iii) the second ends of the fifth and eighth members are connected at each distant point; and
(iv) the second ends of the sixth and seventh members being connected at each distant point.

The trunk line cable comprises first, second, third and fourth elongate electrically conductive members. For any segments of the trunk line along which detection of an event is not required, the cable can simply comprise four insulated wires which are of low resistance. For any extended segments along which detection of an event is required, the trunk cable can comprise two low resistance insulated wires and two high resistance conductive-polymer-coated wires which become electrically connected to each other if an event occurs, eg. a leak of water or another electrolyte, or a leak of a hydrocarbon or other organic fluid which causes swelling of a component in the cable, thus effecting electrical connection; the high resistance wires are preferably identical and have a resistance per unit length which is substantially invariable under the operating conditions. The trunk cable can also comprise spaced-apart locations at which connection between the source and locating members takes place upon occurrence of an event, eg. through the operation of switch. One form of switch is a pair of conductive-polymer-coated wires which extend from the trunk cable; one wire is connected to the source member and the other to the locating member. The pair of wires can be part of a zone cable which extends from the trunk cable and which comprises in addition two insulated low resistance wires which are connected as a loop to form part of the return member and thus enable the continuity of the system to be checked.

The branch line cable can have the same characteristics as are described above for the trunk line cable, except that at least part of the branch line comprises members which, upon occurrence of an event, become electrically connected. However, the invention is particularly useful when the branch line cable comprises two low resistance insulated wires (which may be the same or different) and two conductive-polymer-coated wires (which are preferably the same), particularly when at least part of the trunk cable has substantially the same physical construction as the branch line cable. Particularly under such circumstances, it is preferred to put resistors in the connections between the conductive-polymer-coated wires; this results in discontinuities in the possible readings of the voltage-measuring device, so that despite a small error in the reading, the location of the event can be identified as being in the trunk line or branch line, as the case may be.

Preferably the sensor cable according to the invention is such that at least one of the branch line cables comprises at least one zone cable which extends from the branch line cable at a sub-intermediate point and follows an elongate zone path from the sub-intermediate point to a zone distant point, the zone cable comprising ninth, tenth, eleventh, and twelfth elongate electrically conductive members, each of which runs continuously along the whole length of the zone path and has a first end at the sub-intermediate point and a second end at the zone distant point;
each of the fifth and sixth members runs continuously along the whole length of the branch path, one of the seventh and eighth members runs along the whole length of the branch path, and the other of the seventh and eighth members runs along the whole length of the branch path but is discontinuous at each sub-intermediate point to provide an incoming and nearer to the intermediate point and an outgoing end nearer to distant point;
the first ends of the ninth and tenth members are connected to the fifth and sixth members respectively at the sub-intermediate point;
the ninth and tenth members (a) are, in the absence of an event, insulated from each other and from other components of the cable except for said connections at the sub-intermediate point, and (b) become, upon occurrence of an event at a point along the zone path, electrically connected to each other at that point;
the near ends of the eleventh and twelfth members are respectively connected to the incoming and outgoing ends of the seventh or eighth members at the sub-intermediate point, and the far ends of the eleventh and twelfth members are connected to each other at the zone distant point;
the eleventh and twelfth members are insulated from each other and from other components of the cable, except for said connections at the sub-intermediate point and at the zone distant point, both in the absence of an event and upon occurrence of an event; and
the cable includes, adjacent to each sub-intermediate point, two identical resistors, one forming part of the fifth member before the sub-intermediate point and the other forming part of the sixth member after the sub-intermediate point.

A very useful attribute of the apparatus using the sensor cable of the present invention is that it can be assembled at an installation site from pre-terminated cables and preassembled connection and termination units which can be manufactured in a factory, thus eliminated the need to carry out in situ wiring, with the attendant risk of error. The various connection and termination units can be assembled (and if desired sealed) as flexible harnesses or in boxes.

Referring now to the drawing, each of the Figures is a current diagram of an apparatus which comprises
(A) a constant current power supply (100);
(B) a high impedance voltmeter (200);
(C) a trunk line cable which has a near end (300) and a far end (400), and which is made up of a plurality of segments, each segment comprising a first member (11, 12, 13 etc.), a second member (21, 22, 23 etc.), a third member (31, 32, 33 etc.) and a fourth member (41, 42, 43 etc.); and
(D) at least one branch line cable which extends from an intermediate point (500) along the trunk path to a distant point (600) and which is made up of one or more segments, each segment comprising a fifth member (51, 52, 53 etc.), a sixth member (61, 62, 63 etc.), a seventh member (71, 72, 73 etc.) and an eighth member (81, 82, 83 etc.).
In each of the Figures, the phantom lines enclose components which can conveniently be preassembled in a manufacturing facility (eg. as a box or a flexible harness), with appropriate connecting means for the cables which make up the rest of the apparatus. The pre-assembled parts and the cables can then be assembled at the site of the installation.

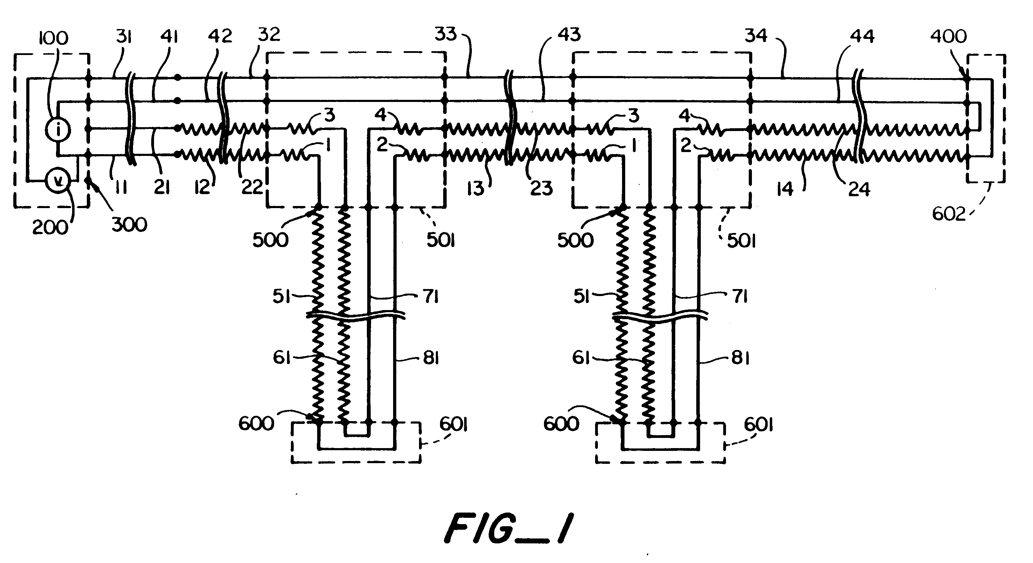

Referring now to Figure 1, this comprises a trunk cable having two identical branch cables connected thereto in accordance with the first embodiment of the invention. The segment of the trunk cable closest to the near end 300 comprises four low resistance insulated wires 11, 21, 31 and 41 and extends along a path along which detection of an event is not required. The second, third and fourth segments of trunk cable comprise two low resistance insulated wires 32, 33 and 34, and 42, 43 and 44, and two identical high resistance conductive-polymer-coated wires 12, 13 and 14, and 22, 23 and 24 which become connected to each other if an event occurs, eg. a leak of water or a hydrocarbon. At each intermediate point 500, the trunk cable and the branch cable are connected to a preassembled T-connector 501 which will not detect occurrence of an event, which makes the connections shown, and which includes four identical resistors 1, 2, 3 and 4. The branch cable has a single segment which runs from the intermediate point 500 to the distant point 600 and which has the same physical construction as the second segment of the trunk cable and comprises two low resistance insulated wires 71 and 81 and two identical high resistance conductive-polymer-coated wires 51 and 61 which become connected to each other if an event occurs. At the distant point 600, the branch cable is connected to a preassembled terminator 601 which makes the connections shown. The final segment of the trunk cable is connected to a preassembled terminator 602 which makes the connections shown and which can be identical to terminator 601.

The wires 11, 12, 51 and 13, the resistors 1 and 2, and the connections between them together form a locating member. The wires 21, 22, 61 and 23, the resistors 3 and 4, and the connections between them together form a source member.

When the occurrence of an event causes a connection to be made at a single point along the trunk or branch cables (ie. between members 12 and 22, or members 51 and 61, or members 13 and 23), the voltage measured by the voltmeter depends upon the resistance of the locating member between the near end 300 and the connection point. Through knowledge of the resistance per unit length of the various components, or through prior mapping of the system, the measured voltage indicates the location of the event. The resistors 1, 2, 3 and 4 ensure that, despite a small error in the voltage measurement, an operator can distinguish between an event at an end of the trunk cable close to a T-connector and an event at the end of a branch cable close to a T-connector or at the end of a branch cable close to a terminator 601.

In Figure 1, the connections in the T-connector are between members 51 and 12, 61 and 22, 71 and 23, and 81 and 13. However, since the members 71 and 81 have much lower resistance than the members 51 and 61, results which are substantially the same could be obtained by making the connections between 51 and 12 (as before), 81 and 13 (as before), 61 and 23, and 71 and 22; and results which are equally accurate, or substantially as accurate, but in which locations on the branch line were measured from the distant point instead of the intermediate point, could be obtained by making the connections between 12 and 71, 22 and 81, 51 and 23, and 61 and 13 (equally accurate) or between 12 and 71, 22 and 51, 81 and 23, and 61 and 13 (substantially as accurate).

Figure 1 shows two branch lines, but there could be any number of branch lines.

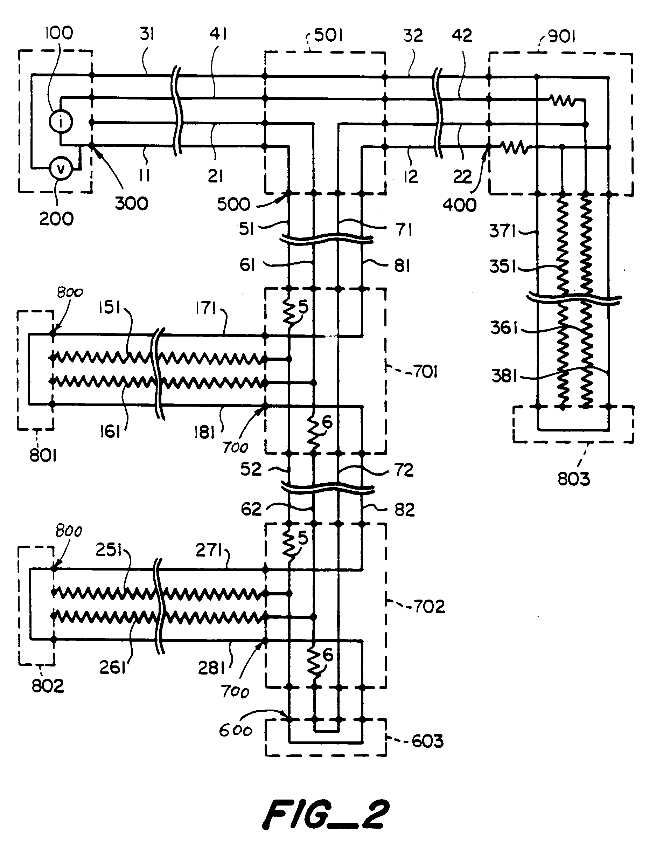

Referring now to Figure 2, this shows a system which will detect the occurrence of an event in one of a plurality of zones, but not elsewhere, and will identify the zone in which the event took place, but will not identify the location of the event in the zone. Between the zones, both the trunk cable and the branch cable comprise four insulated low resistance wires. In each zone, a first conductive-polymer-coated wire extends from the locating member, and a second conductive-polymer-coated wire extends from the source member, close to but not touching the first wire; upon occurrence of an event anywhere in the zone, the first and second wires are brought into electrical contact, thus connecting the source and locating members. Resistors are placed in the locating member so that the voltage measured by the voltmeter identifies the zone in which an event has taken place, and balancing resistors are placed in the source member.

The segment of the trunk cable closest to the near end 300 comprises four low resistance wires 11, 21, 31 and 41. At the intermediate point 500, the trunk cable and the branch cable are connected to a pre-assembled T-connector 501 which makes the connections shown. The first segment of the branch cable has the same physical construction as the trunk cable and contains four low resistance insulated wires, and is connected to a T-zone connector 701, which makes the connections shown between a zone cable and the first and second segments of the branch cable, and which contains resistors 5 and 6. The zone cable has the same physical construction as the branch cable of Figure 1, and contains two low resistance insulated wires 171 and 181 and two conductive-polymer-coated wires 151 and 161. It is, however, connected differently both at the T-zone connector 701 and at the zone terminator 801; the wires 171 and 181 are connected as a loop between insulated wires 81 and 82 so that it is possible to make a continuity check of the zone cable. The second segment of the branch cable likewise contains four insulated wires 52, 62, 72 and 82. The second segment is connected to another T-zone connector 702 which is the same as 701 and to which is connected a second zone cable comprising insulated wires 271 and 281 and conductive-polymer-coated wires 251 and 261 and terminating in zone terminator 802. Terminator 603, which can be the same as terminator 601 used in Figure 1 makes the appropriate connections at the end of the branch line.

The second segment of the trunk cable, comprising four insulated wires 12, 22, 32 and 42, is connected via an end zone connector 901 to a zone cable which is like that in the other zones, which comprises two insulated wires 371 and 381 and two conductive-polymer-coated wires 351 and 361, and which is connected to zone terminator 803.

## Claims

1. A sensor cable for use in detecting and obtaining information about an event, the cable comprising
(A) a trunk line cable which follows an elongate trunk path having a near end (300) and a far end (400); and which comprises elongate electrically conductive members; and
(B) at least one branch line cable which also comprises elongate electrically conductive members and which extends from the trunk line cable at an intermediate point (500) along the trunk path and follows an elongate branch path from the intermediate point (500) to a distant point (600);
the occurrence of an event resulting in an electrical connection between two of said elongate electrically conductive members, characterized in that
the trunk line cable comprises four elongate electrically conductive members,
each of the first (11, 12, ...) and second (21, 22, ...) members running along the whole length of the trunk path but being discontinuous at each intermediate point (500) to provide an incoming end nearer to the near end (300) of the trunk path and an outgoing end nearer to the far end (400) of the trunk path,
each of the third (31, 32, ...) and fourth (41, 42, ...) members running continuously along the whole length of the trunk path,
the first and third members being electrically connected to each other at the far end (400) of the trunk cable, and the second and fourth members being electrically connected to each other at the far end (400) of the trunk cable;
the at least one branch line cable comprises a fifth (51), sixth (61), seventh (71), and eighth (81) elongate electrically conductive member, each of which runs continuously along the whole length of the branch path and has a first end at the intermediate point (500) and a second end at the distant point (600);
each of the first ends of the fifth, sixth, seventh and eighth members is respectively connected to one of the incoming and outgoing ends of the first and second members, and each of the second ends of the fifth and sixth members is respectively connected to each of the second ends of the seventh and eighth members;
the first and second members (a) are, in the absence of an event, insulated from each other and from other components of the cable along the length of the cable except for said connections at each intermediate point (500) and at the far end (400) of the trunk cable, and (b) become, upon occurrence of an event at a point along the trunk path electrically connected to each other at said point;
the third and fourth members are, both in the absence of an event and upon occurrence of an event, electrically insulated from each other and from other components of the cable, along the length of the cable, except for said connections at the far end (400) of the trunk cable;
the fifth (51) and sixth (61) members (a) are, in the absence of an event, insulated from each other and from other components of the cable except for said connections at each intermediate point (500) and distant point (600), and (b) become, upon occurrence of an event at a point along the branch path, electrically connected to each other at that point; and
the seventh (71) and eighth (81) members are, both in the absence of an event and upon occurrence of an event, electrically insulated from each other and from other components of the cable except for said connections at each intermediate point (500) and distant point (600).

2. A cable according to Claim 1 characterized in that
(i) the incoming ends of the first (11, 12, 13 . . .) and second (21, 22, 23 . . .) members at each intermediate point (500) are connected to the first ends of the fifth (51) and sixth (61) members respectively, or to the first ends of the seventh (71) and eighth (81) members respectively;
(ii) the outgoing ends of the first (11, 12, 13 . . .) and second (21, 22, 23 . . .) members at each intermediate point (500) are connected to the first ends of the eighth (81) and seventh (71) members respectively, or to the first ends of the fifth (51) and sixth (61) members respectively;
(iii) the second ends of the fifth (51) and eighth (81) members are connected at each distant point (600); and
(iv) the second ends of the sixth (61) and seventh (71) members are connected at each distant point (600).

3. A cable according to Claim 1 or 2 characterized in that the physical construction of at least a part of the trunk cable is identical to the physical construction of at least a part of the at least one branch cable.

4. A cable according to any one of the preceding claims characterized in that at least a part of each of the fifth and sixth members comprises a metallic wire which is electrically surrounded by a conductive polymer.

5. A cable according to any one of the preceding claims characterized in that it includes four identical resistors (1, 2, 3, 4) adjacent to each intermediate point, each resistor providing one of said connections between the first ends of the fifth, sixth, seventh and eighth members and the incoming and outgoing ends of the first and second members respectively.

6. A cable according to any one of the preceding claims characterized in that the trunk cable comprises a plurality of preterminated lengths of cable, each length comprising a part of the first, second, third and fourth members; each branch cable comprises a preterminated length of cable which comprises the fifth, sixth, seventh and eighth members; at each intermediate point, the preterminated lengths and the trunk cable and the branch cables are terminated by identical termination units; and the trunk cable and the branch cables are terminated by identical termination units.

7. A cable according to any one of claims 1 to 4 characterized in that
at least one of the branch line cables comprises at least one zone cable which extends from the branch line cable at a sub-intermediate point (700) and follows an elongate zone path from the sub-intermediate point (700) to a zone distant point (800), the zone cable comprising ninth (151, 251), tenth (161, 261), eleventh (171, 271), and twelfth (181, 281) elongate electrically conductive members, each of which runs continuously along the whole length of the zone path and has a first end at the sub-intermediate point (700) and a second end at the zone distant point (800);
each of the fifth (51, 52) and sixth (61, 62) members runs continuously along the whole length of the branch path, one of the seventh (71, 72) and eighth (81, 82) members runs along the whole length of the branch path, and the other of the seventh (71, 72) and eighth (81, 82) members runs along the whole length of the branch path but is discontinuous at each sub-intermediate point (700) to provide an incoming end nearer to the intermediate point (500) and an outgoing end nearer to distant point (600);
the first ends of the ninth (151, 251) and tenth (161, 261) members are connected to the fifth (51,52) and sixth (61, 62) members respectively at the sub-intermediate point (700);
the ninth and tenth members (a) are, in the absence of an event, insulated from each other and from other components of the cable except for said connections at the sub-intermediate point, and (b) become, upon occurrence of an event at a point along the zone path, electrically connected to each other at that point;
the near ends of the eleventh and twelfth members are respectively connected to the incoming and outgoing ends of the seventh or eighth members at the sub-intermediate point (700), and the far ends of the eleventh and twelfth members are connected to each other at the zone distant point (800);
the eleventh and twelfth members are insulated from each other and from other components of the cable, except for said connections at the sub-intermediate point (700) and at the zone distant point (800), both in the absence of an event and upon occurrence of an event; and
the cable includes, adjacent to each sub-intermediate point (700), two identical resistors, one (5) forming part of the fifth member before the sub-intermediate point (700) and the other (6) forming part of the sixth member alter the sub-intermediate point (700).

## Patentansprüche

1. Sensorkabel zur Verwendung beim Detektieren und Erhalten von Information über ein Ereignis, wobei das Kabel aufweist:
(A) ein Fernleitungskabel, das einem langen Fernleitungsweg folgt, der ein nahes Ende (300) und ein fernes Ende (400) hat; und das lange elektrisch leitfähige Elemente aufweist; und
(B) wenigstens ein Abzweigleitungskabel, das ebenfalls lange elektrisch leitfähige Elemente aufweist und von dem Fernleitungskabel von einem Zwischenpunkt (500) entlang dem Fernleitungsweg verläuft und einem langen Abzweigweg von dem Zwischenpunkt (500) zu einem fernen Punkt (600) folgt;
wobei das Auftreten eines Ereignisses in einer elektrischen Verbindung zwischen zwei der genannten langen elektrisch leitfähigen Elemente resultiert, dadurch gekennzeichnet, daß
das Fernleitungskabel vier lange elektrisch leitfähige Elemente aufweist,
wobei das erste (11, 12, ...) und das zweite (21, 22, ...) Element jeweils entlang der Gesamtlänge des Fernleitungswegs verlaufen, jedoch an jedem Zwischenpunkt (500) diskontinuierlich sind, um ein ankommendes Ende, das dem nahen Ende (300) des Fernleitungswegs näher ist, und ein abgehendes Ende, das dem fernen Ende (400) des Fernleitungswegs näher ist, zu bilden,
das dritte (31, 32, ...) und das vierte (41, 42, ...) Element jeweils kontinuierlich entlang der Gesamtlänge des Fernleitungswegs verlaufen,
das erste und das dritte Element an dem fernen Ende (400) des Fernleitungskabels elektrisch miteinander verbunden sind und das zweite und das vierte Element an dem fernen Ende (400) des Fernleitungskabels elektrisch miteinander verbunden sind;
das wenigstens eine Abzweigleitungskabel ein fünftes (51), sechstes (61), siebtes (71) und achtes (81) langes elektrisch leitfähiges Element aufweist, die jeweils kontinuierlich entlang der Gesamtlänge des Abzweigwegs verlaufen und an dem Zwischenpunkt (500) ein erstes Ende sowie an dem fernen Punkt (600) ein zweites Ende haben;
die ersten Enden des fünften, sechsten, siebten und achten Elements jeweils entweder mit den ankommenden oder abgehenden Enden des ersten und zweiten Elements verbunden sind und die zweiten Enden des fünften und sechsten Elements jeweils mit jedem der zweiten Enden des siebten und achten Elements verbunden sind;
das erste und zweite Element (a) bei Abwesenheit eines Ereignisses voneinander und von anderen Komponenten des Kabels entlang der Länge des Kabels isoliert sind mit Ausnahme der Verbindungen an jedem Zwischenpunkt (500) und an dem fernen Ende (400) des Fernleitungskabels und (b) bei Auftreten eines Ereignisses an einem Punkt entlang dem Fernleitungsweg an diesem Punkt elektrisch miteinander verbunden werden;
das dritte und vierte Element sowohl bei Abwesenheit eines Ereignisses als auch bei Auftreten eines Ereignisses voneinander und von anderen Komponenten des Kabels entlang der Länge des Kabels elektrisch isoliert sind mit Ausnahme der genannten Verbindungen an dem fernen Ende (400) des Fernleitungskabels;
das fünfte (51) und sechste (61) Element (a) bei Abwesenheit eines Ereignisses voneinander und von anderen Komponenten des Kabels isoliert sind mit Ausnahme der genannten Verbindungen an jedem Zwischenpunkt (500) und dem fernen Punkt (600) und (b) bei Auftreten eines Ereignisses an einem Punkt entlang dem Abzweigweg an diesem Punkt elektrisch miteinander verbunden werden; und
das siebte (71) und achte (81) Element sowohl bei Abwesenheit eines Ereignisses als auch bei Auftreten eines Ereignisses voneinander und von anderen Komponenten des Kabels elektrisch isoliert sind mit Ausnahme der genannten Verbindungen an jedem Zwischenpunkt (500) und dem fernen Punkt (600).

2. Kabel nach Anspruch 1, dadurch gekennzeichnet, daß
(i) die ankommenden Enden des ersten (11, 12, 13, ...) und zweiten (21, 22, 23, ...) Elements an jedem Zwischenpunkt (500) jeweils mit den ersten Enden des fünften (51) und sechsten (61) Elements verbunden sind oder jeweils mit den ersten Ende des siebten (71) und achten (81) Elements verbunden sind;
(ii) die abgehenden Enden des ersten (11, 12, 13, ...) und zweiten (21, 22, 23, ...) Elements an jedem Zwischenpunkt (500) jeweils mit den ersten Enden des achten (81) und siebten (71) Elements verbunden sind oder jeweils mit den ersten Enden des fünften (51) und sechsten (61) Elements verbunden sind;
(iii) die zweiten Enden des fünften (51) und achten (81) Elements an jedem fernen Punkt (600) verbunden sind; und
(iv) die zweiten Enden des sechsten (61) und siebten (71) Elements an jedem fernen Punkt (600) verbunden sind.

3. Kabel nach Anspruch 1 oder 2, dadurch gekennzeichnet, daß die physische Konstruktion wenigstens eines Teils des Fernleitungskabels mit der physischen Konstruktion wenigstens eines Teils des wenigstens einen Abzweigleitungskabels identisch ist.

4. Kabel nach einem der vorhergehenden Ansprüche, dadurch gekennzeichnet, daß wenigstens ein Teil sowohl des fünften als auch des sechsten Elements einen metallischen Draht aufweist, der von einem leitfähigen Polymer elektrisch umgeben ist.

5. Kabel nach einem der vorhergehenden Ansprüche, dadurch gekennzeichnet, daß es vier identische Widerstände (1, 2, 3, 4) angrenzend an jeden Zwischenpunkt aufweist, wobei die Widerstände jeweils eine der genannten Verbindungen zwischen den ersten Enden des fünften, sechsten, siebten und achten Elements und den ankommenden und abgehenden Enden des ersten und zweiten Elements herstellen.

6. Kabel nach einem der vorhergehenden Ansprüche, dadurch gekennzeichnet, daß das Fernleitungskabel eine Vielzahl von vor-terminierten Kabellängen aufweist, wobei jede Länge einen Teil des ersten, zweiten, dritten und vierten Elements aufweist; daß jedes Abzweigleitungskabel eine vor-terminierte Kabellänge aufweist, die das fünfte, sechste, siebte und achte Element aufweist; daß an jedem Zwischenpunkt die vorterminierten Längen und das Fernleitungskabel sowie die Abzweigleitungskabel durch identische Terminiereinheiten terminiert sind; und daß das Fernleitungskabel und die Abzweigleitungskabel durch identische Terminiereinheiten terminiert sind.

7. Kabel nach einem der Ansprüche 1 bis 4, dadurch gekennzeichnet, daß
wenigstens eines der Abzweigleitungskabel wenigstens ein Zonenkabel aufweist, das von dem Abzweigleitungskabel von einem Unter-Zwischenpunkt (700) verläuft und einem langen Zonenweg von dem Unter-Zwischenpunkt (700) zu einem fernen Zonenpunkt (800) folgt, wobei das Zonenkabel ein neuntes (151, 251), zehntes (161, 261), elftes (171, 271) und zwölftes (181, 281) langes elektrisch leitfähiges Element aufweist, die jeweils kontinuierlich entlang der Gesamtlänge des Zonenwegs verlaufen und ein erstes Ende an dem Unter-Zwischenpunkt (700) und ein zweites Ende an dem fernen Zonenpunkt (800) haben;
das fünfte (51, 52) und sechste (61, 62) Element jeweils kontinuierlich entlang der Gesamtlänge des Abzweigwegs verlaufen, entweder das siebte (71, 72) oder das achte (81, 82) Element entlang der Gesamtlänge des Abzweigwegs verläuft und das jeweils andere des siebten (71, 72) und achten (81, 82) Elements entlang der Gesamtlänge des Abzweigwegs verläuft, jedoch an jedem Unter-Zwischenpunkt (700) diskontinuierlich ist, um ein ankommendes Ende, das dem Zwischenpunkt (500) näher ist, und ein abgehendes Ende, das dem fernen Punkt (600) näher ist, zu bilden;
die ersten Enden des neunten (151, 251) und zehnten (161, 261) Elements jeweils mit dem fünften (51, 52) und sechsten (61, 62) Element an dem Unter-Zwischenpunkt (700) verbunden sind;
das neunte und zehnte Element (a) bei Abwesenheit eines Ereignisses voneinander und von anderen Komponenten des Kabels isoliert sind mit Ausnahme der Verbindungen an dem Unter-Zwischenpunkt und (b) bei Auftreten eines Ereignisses an einem Punkt entlang dem Zonenweg an diesem Punkt elektrisch miteinander verbunden werden;
die nahen Enden des elften und zwölften Elements jeweils mit den ankommenden und abgehenden Enden des siebten oder achten Elements an dem Unter-Zwischenpunkt (700) verbunden sind und die fernen Enden des elften und zwölften Element an dem fernen Zonenpunkt (800) miteinander verbunden sind;
das elfte und zwölfte Element sowohl bei Abwesenheit eines Ereignisses als auch bei Auftreten eines Ereignisses voneinander und von anderen Komponenten des Kabels isoliert sind mit Ausnahme der genannten Verbindungen an dem Unter-Zwischenpunkt (700) und an dem fernen Zonenpunkt (800); und
das Kabel angrenzend an jeden Unter-Zwischenpunkt zwei identische Widerstände aufweist, wobei einer (5) Teil des fünften Elements vor dem Unter-Zwischenpunkt (700) und der andere (6) Teil des sechsten Elements nach dem Unter-Zwischenpunkt (700) bildet.

## Revendications

1. Câble capteur à utiliser dans la détection et l'obtention d'informations concernant un événement, le câble comportant
(A) un câble de ligne principale qui suit un trajet principal allongé ayant une extrémité rapprochée (300) et une extrémité éloignée (400), et qui comporte des éléments allongés électriquement conducteurs ; et
(B) au moins un câble de ligne de ramification qui comprend aussi des éléments allongés électriquement conducteurs et qui s'étend depuis le câble de ligne principale en un point intermédiaire (500) le long du trajet principal et suit un trajet allongé de ramification depuis le point intermédiaire (500) jusqu'à un point distant (600) ;
l'apparition d'un événement ayant pour résultat une connexion électrique entre deux desdits éléments allongés électriquement conducteurs, caractérisé en ce que
le câble de ligne principale comporte quatre éléments allongés électriquement conducteurs,
chacun des premier (11, 12, ...) et deuxième (21, 22, ...) éléments s'étendant sur toute la longueur du trajet principal, mais étant discontinu en chaque point intermédiaire (500) pour présenter une extrémité entrante plus proche de l'extrémité rapprochée (300) du trajet principal et une extrémité sortante plus proche de l'extrémité éloignée (400) du trajet principal,
chacun des troisième (31, 32, ...) et quatrième (41, 42, ...) éléments s'étendant en continu sur toute la longueur du trajet principal,
les premier et troisième éléments étant connectés électriquement l'un à l'autre à l'extrémité éloignée (400) du câble principal, et les deuxième et quatrième éléments étant connectés électriquement l'un à l'autre à l'extrémité éloignée (400) du câble principal ;
le ou chaque câble de ligne de ramification comporte des cinquième (51), sixième (61), septième (71) et huitième (81) éléments allongés électriquement conducteurs dont chacun s'étend en continu sur toute la longueur du trajet de ramification et comporte une première extrémité au point intermédiaire (500) et une seconde extrémité au point distant (600) ;
chacune des premières extrémités des cinquième, sixième, septième et huitième éléments est connectée, respectivement, à l'une des extrémités entrante et sortante des premier et deuxième éléments, et chacune des secondes extrémités des cinquième et sixième éléments est connectée, respectivement, à chacune des secondes extrémités des septième et huitième éléments ;
les premier et deuxième éléments (a) sont, en l'absence d'un événement, isolés l'un de l'autre et d'autres constituants du câble sur la longueur du câble à l'exception desdites connexions en chaque point intermédiaire (500) et à l'extrémité éloignée (400) du câble principal, et (b) viennent, à la suite de l'apparition d'un événement en un point le long du trajet principal, en connexion électrique l'un avec l'autre audit point ;
les troisième et quatrième éléments sont, à la fois en l'absence d'un événement et à la suite de l'apparition d'un événement, isolés électriquement l'un de l'autre et d'autres constituants du câble, sur la longueur du câble, à l'exception desdites connexions à l'extrémité éloignée (400) du câble principal ;
les cinquième (51) et sixième (61) éléments (a) sont, en l'absence d'un événement, isolés l'un de l'autre et d'autres constituants du câble à l'exception desdites connexions en chaque point intermédiaire (500) et au point distant (600), et (b) viennent, à la suite de l'apparition d'un événement en un point le long du trajet de ramification, en connexion électrique l'un avec l'autre en ce point ; et
les septième (71) et huitième (81) éléments sont, à la fois en l'absence d'un événement et à la suite de l'apparition d'un événement, isolés électriquement l'un de l'autre et d'autres constituants du câble à l'exception desdites connexions à chaque point intermédiaire (500) et au point distant (600).

2. Câble selon la revendication 1, caractérisé en ce que
(i) les extrémités entrantes des premier (11, 12, 13, ...) et deuxième (21, 22, 23, ...) éléments en chaque point intermédiaire (500) sont connectées aux premières extrémités des cinquième (51) et sixième (61) éléments, respectivement, ou aux premières extrémités des septième (71) et huitième (81) éléments, respectivement ;
(ii) les extrémités sortantes des premier (11, 12, 13, ...) et deuxième (21, 22, 23, ...) éléments en chaque point intermédiaire (500) sont connectées aux premières extrémités des huitième (81) et septième (71) éléments, respectivement, ou aux premières extrémités des cinquième (51) et sixième (61) éléments, respectivement ;
(iii) les secondes extrémités des cinquième (51) et huitième (81) éléments sont connectées en chaque point distant (600) ; et
(iv) les secondes extrémités des sixième (61) et septième (71) éléments sont connectées en chaque point distant (600).

3. Câble selon la revendication 1 ou 2, caractérisé en ce que la construction physique d'au moins une partie du câble principal est identique à la construction physique d'au moins une partie du ou de chaque câble de ramification.

4. Câble selon l'une quelconque des revendications précédentes, caractérisé en ce qu'au moins une partie de chacun des septième et sixième éléments comprend un fil métallique qui est entouré électriquement d'un polymère conducteur.

5. Câble selon l'une quelconque des revendications précédentes, caractérisé en ce qu'il comprend quatre résistances identiques (1, 2, 3, 4) adjacentes à chaque point intermédiaire, chaque résistance établissant l'une desdites connexions entre les premières extrémités des cinquième, sixième, septième et huitième éléments et les extrémités entrantes et sortantes des premier et deuxième éléments, respectivement.

6. Câble selon l'une quelconque des revendications précédentes, caractérisé en ce que le câble principal comprend plusieurs longueurs prédéterminées de câble, chaque longueur comprenant une partie des premier, deuxième, troisième et quatrième éléments ; chaque câble de ramification comporte une longueur prédéterminé de câble qui comprend les cinquième, sixième, septième et huitième éléments ; en chaque point intermédiaire, les longueurs prédéterminées et le câble principal et les câbles de ramification sont terminés par des unités de terminaison identiques ; et le câble principal et les câbles de ramification sont terminés par des unités de terminaison identiques.

7. Câble selon l'une quelconque des revendications 1 à 4, caractérisé en ce que
au moins l'un des câbles des lignes de ramification comprend au moins un câble de zone qui s'étend depuis le câble de ligne de ramification en un point sous-intermédiaire (700) et suit un trajet allongé de zone à partir du point sous-intermédiaire (700) jusqu'à un point distant (800) de zone, le câble de zone comprenant des neuvième (151, 251), dixième (161, 261), onzième (171, 271) et douzième (181, 281) éléments allongés électriquement conducteurs, dont chacun s'étend de façon continue sur toute la longueur du trajet de zone et présente une première extrémité au point sous-intermédiaire (700) et une seconde extrémité au point distant (800) de zone ;
chacun des cinquième (51, 52) et sixième (61, 62) éléments s'étend de façon continue sur toute la longueur du trajet de ramification, l'un des septième (71, 72) et huitième (81, 82) éléments s'étend sur toute la longueur du trajet de ramification et l'autre des septième (71, 72) et huitième (81, 82) éléments s'étend sur toute la longueur du trajet de ramification, mais est discontinu en chaque point sous-intermédiaire (700) pour présenter une extrémité entrante plus proche du point intermédiaire (500) et une extrémité sortante plus proche du point distant (600) ;
les premières extrémités des neuvième (151, 251) et dixième (161, 261) éléments sont connectées aux cinquième (51, 52) et sixième (61, 62) éléments, respectivement, au point sous-intermédiaire (700) ;
les neuvième et dixième éléments (a) sont, en l'absence d'un événement, isolés l'un de l'autre et d'autres constituants du câble à l'exception desdites connexions au point sous-intermédiaire, et (b) viennent, à la suite de l'apparition d'un événement en un point le long du trajet de zone, en connexion électrique l'un avec l'autre en ce point ;
les extrémités rapprochées des onzième et douzième éléments sont connectées, respectivement, aux extrémités entrante et sortante du septième ou du huitième élément au point sous-intermédiaire (700), et les extrémités éloignées des onzième et douzième éléments étant connectées entre elles au point distant (800) de zone ;
les onzième et douzième éléments sont isolés l'un de l'autre et d'autres constituants du câble, à l'exception desdites connexions au point sous-intermédiaire (700) et au point distant (800) de zone, à la fois en l'absence d'un événement et à la suite de l'apparition d'un événement ; et
le câble comprend, à proximité immédiate de chaque point sous-intermédiaire (700), deux résistances identiques, l'une (5) faisant partie du cinquième élément avant le point sous-intermédiaire (700) et l'autre (6) faisant partie du sixième élément après le point sous-intermédiaire (700).
